# EUROPEAN PATENT APPLICATION

(11) **EP 4 819 820 A1**
(43) Date of publication of application: **07.10.2026**
(21) Application number: 25761528.6
(22) Date of filing: 06.02.2025
(51) Int. Cl.: H10N 50/10, H10B 61/00, H10N 50/80

(54) **FILM, LAMINATE, ELEMENT, DEVICE, AND STRUCTURE**

(30) Priority: 26.02.2024 JP 2024026654
(71) Applicant: SUMITOMO CHEMICAL COMPANY, LIMITED, Tokyo 103-6020 (JP); RIKEN, Wako-shi, Saitama 351-0198 (JP)
(72) Inventor: OKAMOTO, Satoshi, Tokyo 103-6020 (JP); LLANDRO, Justin, Tokyo 103-6020 (JP); NAKAMURA, Daisuke, Wako-shi, Saitama 351-0198 (JP); TAGUCHI, Yasujiro, Wako-shi, Saitama 351-0198 (JP); TOKURA, Yoshinori, Wako-shi, Saitama 351-0198 (JP)
(74) Representative: J A Kemp LLP
(86) International application number: PCT/JP2025/003992
(87) International publication number: WO 2025/182519

(57) **Abstract**

This film contains ferrite represented by the general formula (Ba₁₋ₓSrₓ)₂Co₂Fe_{12-y-δ}Al_{y}X₃O₂₂. X is at least one element selected from the group consisting of Cr, Sb, In, and V. The relationship 0 ≤ x ≤ 1 is satisfied. The relationships 0 < y ≤ 2 and 0 ≤ δ ≤ 1, or 0 ≤ y ≤ 2 and 0 < δ ≤ 1, are satisfied. The film has a film thickness of at least 1.0 nm and less than 70 µm.

## Description

### Technical Field

The present disclosure relates to a film, a laminate, an element, a device, and a structure.

### Background Art

Since the 1990s, IT devices such as personal computers and mobile phones have rapidly become widespread. Representative memory LSIs (Large Scale Integration) that have supported the spread of these devices are DRAM (Dynamic Random Access Memory) and flash memory.

Memory LSIs are required to have large capacity and high-speed response, as well as low power consumption. Non-volatility is essential from the viewpoint of low power consumption. Development of universal memories that satisfy all of these conditions is being actively pursued. Flash memory is an example of a non-volatile memory that is currently in widespread use. Because flash memory operates on the principle of charge injection, its write speed is slow, on the order of microseconds, and the number of rewrite cycles is as few as approximately 10⁶. Therefore, flash memory has many problems to be overcome as a universal memory.

MRAM (Magnetoresistive Random Access Memory) utilizing the magnetoresistive effect is known (see, for example, Patent Documents 1 and 2). In MRAM, layered structures including magnetic elements are arranged in a matrix. Information recorded in individual magnetic elements is read out by utilizing the magnetoresistive effect of the magnetic elements. Writing of information is performed by controlling the magnetization direction of the magnetic elements. Because the magnetization state is substituted for the recording state, the memory is non-volatile in principle. For this reason, MRAM is expected to be a non-volatile memory that satisfies all conditions, including low power consumption, high-speed response, large capacity, write endurance, and compatibility with semiconductors.

### Citation List

### Patent Literature

Patent Document 1: Japanese Unexamined Patent Application Publication No. 2001-196661
Patent Document 2: Japanese Unexamined Patent Application Publication No. 2001-93273
Patent Document 3: Japanese Unexamined Patent Application Publication No. 2016-199411

### Non Patent Literature

Non-Patent Document 1: J. C. Slonczewski, "Current-driven excitation of magnetic multilayers", June 1996, Journal of Magnetism and Magnetic Materials, volume 159, Issues 1-2, pages L1-L7
Non-Patent Document 2: J. E. Mattson et al., "Photoinduced antiferromagnetic interlayer coupling in Fe/(Fe-Si) superlattices", 5 July 1993, Physical Review Letters, 71, 185
Non-Patent Document 3: H. Ohno et al., "Electric-field control of ferromagnetism", 21 December 2000, Nature 408, 944-946

### Summary of Invention

### Technical Problem

Regarding MRAM, when large capacity exceeding the Gbit class is considered, there is a high possibility that the power consumption associated with writing will increase. Therefore, reduction in power consumption is desired.

The present disclosure aims to provide a film, a laminate, an element, a device, and a structure capable of controlling the magnetization direction with low power consumption.

### Solution to Problem

The present inventors conducted extensive studies to solve the above-described problems, and found that a specific ferrite is capable of controlling the magnetization direction with low power consumption, thereby conceiving the present invention.
[1] A film containing a ferrite represented by a general formula (Ba₁₋ₓSrₓ)₂Co₂Fe_{12-y-δ}Al_{y}X_{δ}O₂₂,
   wherein X is at least one element selected from the group consisting of Cr, Sb, In, and V, $0 \leq x \leq 1 ,$ $0 < y \leq 2 and 0 \leq δ \leq 1 , or 0 \leq y \leq 2 and 0 < δ \leq 1 ,$ and
   the film has a thickness of 1.0 nm or more and less than 70 µm.
[2] The film according to [1], wherein X is Cr.
[3] A laminate including:
   a first ferromagnetic layer that is a magnetization pinned layer;
   a second ferromagnetic layer that is a magnetization free layer; and
   the film according to [1] or [2].
[4] An element including the laminate according to [3].
[5] A device including the element according to [4].
[6] A structure including:
   a film containing a ferrite having a hexagonal crystal structure; and
   a pair of conductive layers provided on the film so as to be spaced apart from each other in a first direction parallel to an easy magnetization axis of a crystal of the ferrite,
   wherein a distance between the pair of conductive layers in the first direction is 1 nm or more and less than 18 µm.
[7] The structure according to [6],
   wherein the ferrite is represented by a general formula (Ba₁₋ₓSrₓ)₂Co₂Fe_{12-y-δ}Al_{y}X_{δ}O₂₂,
   X is at least one element selected from the group consisting of Cr, Sb, In, and V, $0 \leq x \leq 1 , and$ $0 < y \leq 2 and 0 \leq δ \leq 1 , or 0 \leq y \leq 2 and 0 < δ \leq 1 .$
[8] A laminate including:
   a first ferromagnetic layer that is a magnetization pinned layer;
   a second ferromagnetic layer that is a magnetization free layer; and
   the structure according to [6] or [7],
   wherein the structure, the first ferromagnetic layer, and the second ferromagnetic layer are laminated in a second direction orthogonal to the easy magnetization axis.
[9] An element including the laminate according to [8].
[10] A device including the element according to [9].

### Advantageous Effects of Invention

According to one aspect of the present disclosure, a film, a laminate, an element, a device, and a structure capable of controlling the magnetization direction with low power consumption are provided.

### Brief Description of Drawings

[FIG. 1] FIG. 1 is a cross-sectional view showing an element according to a first embodiment.
[FIG. 2] FIG. 2 is a cross-sectional view showing an element according to a first modification.
[FIG. 3] FIG. 3 is a cross-sectional view showing an element according to a second modification.
[FIG. 4] FIG. 4 is a cross-sectional view showing an element according to a second embodiment.
[FIG. 5] FIG. 5 is an SEM image showing the arrangement of an insulating substrate, a thin film sample, and a pair of conductive layers.
[FIG. 6] FIG. 6 is a schematic diagram showing the magnetoelectric states of a Y-type hexaferrite thin film.
[FIG. 7] FIG. 7(a) is an MFM image showing the magnetic texture of the Y-type hexaferrite thin film according to Example 1 after a poling treatment. FIG. 7(b) is an MFM image showing the magnetic texture of the Y-type hexaferrite thin film according to Example 1 after application of a pulsed electric field.
[FIG. 8] FIG. 8 is a graph comparing changes in signal intensity of the Y-type hexaferrite thin film according to Example 1.
[FIG. 9] FIG. 9(a) is an MFM image showing the magnetic texture of the Y-type hexaferrite thin film according to Comparative Example 1 after a poling treatment. FIG. 9(b) is an MFM image showing the magnetic texture of the Y-type hexaferrite thin film according to Comparative Example 1 after application of a pulsed electric field.
[FIG. 10] FIG. 10 is a graph comparing changes in signal intensity of the Y-type hexaferrite thin film according to Comparative Example 1.
[FIG. 11] FIG. 11 is a graph showing measurement results of the magnetic moment of the Y-type hexaferrite thin film according to Comparative Example 2.

### Description of Embodiments

Hereinafter, embodiments of the present disclosure will be described in detail with reference to the accompanying drawings. In the description of the drawings, the same or equivalent elements are denoted by the same reference numerals, and duplicate descriptions are omitted.

### (First Embodiment)

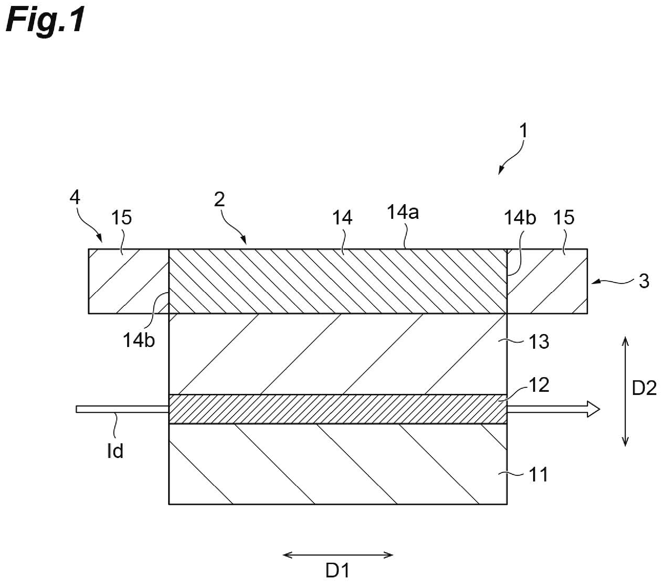

FIG. 1 is a cross-sectional view showing an element according to the first embodiment. An element 1 according to the first embodiment is, for example, an information storage element or a magnetic functional element. The element 1 is a GMR (Giant Magnetoresistance) type element. Examples of a device according to the first embodiment that includes the element 1 include electronic devices such as a magnetic head mounted in a hard disk drive (HDD), a magnetic memory such as MRAM, a magnetic sensor such as a high-sensitivity magnetic sensor, a microwave generating element, or a spin transistor. The element 1 is, for example, a structure having one function in a circuit, and the device is a product manufactured by combining the element 1.

As shown in FIG. 1, the element 1 includes a ferromagnetic layer 11 (first ferromagnetic layer), a non-magnetic metal layer 12, a ferromagnetic layer 13 (second ferromagnetic layer), a film 14, and a pair of conductive layers 15. The element 1 includes a laminate 2 formed by laminating the ferromagnetic layer 11, the non-magnetic metal layer 12, the ferromagnetic layer 13, and the film 14 in this order. The element 1 includes a structure 3 formed of the film 14 and the pair of conductive layers 15. It can also be said that the element 1 includes a laminate 4 formed by laminating the ferromagnetic layer 11, the non-magnetic metal layer 12, the ferromagnetic layer 13, and the structure 3 in this order.

In the following, a direction parallel to an upper surface 14a of the film 14 is referred to as a first direction D1, and a direction perpendicular to the upper surface 14a of the film 14 is referred to as a second direction D2. The upper surface 14a is a surface of the film 14 on the side opposite to the ferromagnetic layer 13. The first direction D1 and the second direction D2 are orthogonal to each other. The lamination direction of both the laminate 2 and the laminate 4 is the second direction D2.

The ferromagnetic layer 11 and the ferromagnetic layer 13 are arranged so as to sandwich the non-magnetic metal layer 12 in the second direction D2. The ferromagnetic layer 11 and the ferromagnetic layer 13 are provided adjacent to the non-magnetic metal layer 12. The ferromagnetic layer 11 is a magnetization pinned layer (reference layer). In the ferromagnetic layer 11, the magnetization direction is fixed in a predetermined direction. The ferromagnetic layer 13 is a magnetization free layer (storage layer). In the ferromagnetic layer 13, the magnetization direction changes easily by magnetization reversal.

The ferromagnetic layer 11 and the ferromagnetic layer 13 are, for example, horizontal magnetization films or in-plane magnetization films that are magnetized parallel to the film surface. The ferromagnetic layer 11 and the ferromagnetic layer 13 are magnetized such that their magnetization directions are parallel to the first direction D1. The ferromagnetic layer 11 and the ferromagnetic layer 13 contain a ferromagnetic material. Examples of the ferromagnetic material include ferromagnetic metals such as iron (Fe), cobalt (Co), and an FeCo alloy, and ferromagnetic half-metals. The ferromagnetic layer 11 and the ferromagnetic layer 13 may contain the same ferromagnetic material as each other, or may contain different ferromagnetic materials from each other.

The non-magnetic metal layer 12 is a spacer layer interposed between the ferromagnetic layer 11 and the ferromagnetic layer 13. The non-magnetic metal layer 12 magnetically separates the ferromagnetic layer 11 and the ferromagnetic layer 13 from each other. The non-magnetic metal layer 12 is formed of a non-magnetic metal such as Cu or Ag, for example. The thickness of the non-magnetic metal layer 12 is, for example, 4 nm. In the element 1, when the magnetization direction of the ferromagnetic layer 13 is the same as the magnetization direction of the ferromagnetic layer 11 (parallel state), the electrical resistance of the non-magnetic metal layer 12 decreases due to the GMR effect, and when it is opposite (antiparallel state), the electrical resistance of the non-magnetic metal layer 12 increases.

The ferromagnetic layer 11, the non-magnetic metal layer 12, and the ferromagnetic layer 13 are deposited by, for example, a sputtering method, an atomic layer deposition method, or an ion plating method. A sputtering method is preferably used.

The film 14 is provided on the ferromagnetic layer 13. The film 14 is provided adjacent to the ferromagnetic layer 13. The film 14 contains, for example, a ferrite represented by a general formula (Ba₁₋ₓSrₓ)₂Co₂Fe_{12-y-δ}Al_{y}X_{δ}O₂₂. The film 14 contains, for example, a ferrite having a hexagonal crystal structure. The film 14 is, for example, a Y-type hexaferrite thin film in which the magnetic moment has a helical structure. This Y-type hexaferrite thin film is preferably a single crystal.

X is at least one element selected from the group consisting of Cr, Sb, In, and V. X is, for example, Cr. x satisfies 0≤x≤1. That is, the film 14 contains at least one of Ba and Sr. y and δ satisfy 0<y≤2 and 0≤δ≤1, or satisfy 0≤y≤2 and 0<δ≤1. That is, the film 14 contains at least one of Al and X. δ may satisfy 0.01≤δ≤0.1.

The thickness of the film 14 is, for example, 1.0 nm or more and less than 70 µm. When the thickness is 1.0 nm or more, the film 14 is easy to manufacture. When the thickness is less than 70 µm, magnetization reversal by a pulse voltage becomes possible. In the film 14, the smaller the thickness, the easier the magnetization reversal. The thickness may be 10 µm or less, or may be 1000 nm or less. The thickness may be 1.0 nm or more and 10 µm or less, or may be 1.0 nm or more and 1000 nm or less. The film 14 is formed by, for example, a method of polishing using a single crystal, a method of processing with a focused ion beam (FIB), a sputtering method, a spray deposition method, a spin coating method, or a plasma laser deposition method.

The film 14 is provided such that the easy magnetization axis of the crystal of the ferrite contained in the film 14 is oriented in the horizontal direction (first direction D1). Hereinafter, the easy magnetization axis of the crystal of the ferrite contained in the film 14 is also simply referred to as the easy magnetization axis. The lamination direction (second direction D2) of the laminate 2 and the laminate 4 is a direction orthogonal to the easy magnetization axis.

The pair of conductive layers 15 are provided on the film 14 so as to be spaced apart from each other in a direction parallel to the easy magnetization axis (first direction D1). In the element 1, both of the pair of conductive layers 15 are provided on side surfaces 14b of the film 14. The pair of conductive layers 15 function as electrodes for applying a voltage to the film 14. The distance (shortest distance) between the pair of conductive layers 15 in the first direction D1 is 1 nm or more and less than 18 µm. When the distance between the pair of conductive layers 15 is 1 nm or more, the film 14 is easy to manufacture. When the distance between the pair of conductive layers 15 is less than 18 µm, magnetization reversal by a pulse voltage becomes possible. The shorter the distance between the pair of conductive layers 15, the easier the magnetization reversal. The distance between the pair of conductive layers 15 may be 2 µm or less. The distance between the pair of conductive layers 15 may be 1 nm or more and 2 µm or less.

The pair of conductive layers 15 contain a conductive material. Examples of the conductive material include titanium nitride (TiN), titanium (Ti), tungsten nitride (WN), tungsten (W), tantalum nitride (TaN), or tantalum (Ta). The pair of conductive layers 15 may be formed of the same conductive material as each other, or may be formed of different conductive materials from each other.

The present inventors found that by applying an electric field to the film 14, it becomes possible to control the magnetization direction of the film 14. That is, in the element 1, by applying a voltage between the pair of conductive layers 15 and applying an electric field in the horizontal direction (first direction D1) to the film 14, the film 14 can be magnetized in the horizontal direction. When the magnetization direction of the film 14 differs from the magnetization direction of the ferromagnetic layer 13, the magnetization direction of the ferromagnetic layer 13 is reversed. Furthermore, by controlling the voltage applied between the pair of conductive layers 15, the magnetization direction of the film 14 can be reversed. As a result, the magnetization direction of the ferromagnetic layer 13 is reversed, and the electrical resistance of the non-magnetic metal layer 12 changes. The change in the electrical resistance of the non-magnetic metal layer 12 can be detected by measuring a current Id flowing through the non-magnetic metal layer 12 in the horizontal direction (first direction D1).

Conventionally, two methods have been mainly proposed as methods for controlling the magnetization direction of MRAM. The first method is a method using a classical current magnetic field, and utilizes wiring arranged in the immediate vicinity of a target magnetic element. However, this method has the following problems: (1) the smaller the size of the magnetic element, the larger the required current; and (2) a write error occurs in a magnetic element adjacent to the target magnetic element due to a leakage magnetic field from the wiring. For this reason, the first method is considered to be inapplicable to Gbit-class large-capacity MRAM.

The second method is expected to be capable of solving the problems of the first method. The second method is a method using spin-transfer magnetization reversal (see Non-Patent Document 1). Spin-transfer magnetization reversal is a phenomenon that occurs when the spin angular momentum of conduction electrons is directly transferred to the localized spins of a magnetic element. The current density required for reversal does not depend on the element size. Therefore, in theory, the smaller the element size, the smaller the required write current. For this reason, the second method is attracting attention as a promising write method for next-generation MRAM. However, since the critical current density required for writing cannot be sufficiently reduced at present, the reduction in power consumption has not yet reached the level that surpasses competing memories.

Conventionally, several methods have also been proposed for inducing a magnetic response by an electric field effect on an element. For example, Non-Patent Document 2 proposes a method of changing the magnetic interlayer exchange coupling generated through a semiconductor layer by the carrier concentration in the semiconductor layer in a sandwich structure in which a very thin semiconductor layer is sandwiched between two ferromagnetic layers. The carrier concentration in the semiconductor layer is controlled by an applied electric field. Patent Document 1 proposes a method of controlling the interlayer exchange coupling between ferromagnetic layers through a non-magnetic layer by utilizing modulation of the surface barrier height at the semiconductor (or insulator)/ferromagnetic layer interface caused by application of a voltage, in a sandwich structure formed of a ferromagnetic layer/non-magnetic layer/ferromagnetic layer grown on a semiconductor (or insulator). Such magnetization reversal control by electric field stimulation has a high possibility of realizing information writing with lower power consumption than methods utilizing a current magnetic field (external magnetic field) or a spin-transfer effect. Therefore, application to a non-volatile compact solid-state magnetic memory is expected.

Patent Document 2 proposes a method of controlling the magnetization state by inducing magnetostriction, in which a piezoelectric/electrostrictive material such as PZT capable of inducing electrical stimulation is configured to be in contact with a magnetic material. However, at present, the fatigue resistance of the piezoelectric/electrostrictive material is not sufficient, which is a problem. Non-Patent Document 3 proposes a method of controlling ferromagnetism by applying an electric field to a ferromagnetic semiconductor InMnAs to change the carrier density. However, since a ferromagnetic semiconductor with a Curie temperature exceeding room temperature has not been realized, this method has not yet been applied in practice.

Regarding methods for inducing a magnetic response by an electric field effect, there are no reported examples of realization even at the level of basic research, let alone application. Furthermore, when considering magnetization reversal control using an electric field by modulating the interlayer exchange coupling force of a ferromagnetic layer/non-magnetic layer/ferromagnetic layer structure by controlling the surface barrier height of a semiconductor or insulator, it is necessary for the quantum interference effect, which is the origin of the interlayer exchange coupling, to occur over multiple layers. Therefore, a very high-quality layered structure is required. For example, the only cases in which the oscillation phenomenon of interlayer exchange coupling involving a ferromagnetic layer has been observed so far are epitaxially grown Fe/Au and Fe/Cr systems. For this reason, there are very severe restrictions when application is considered. With the methods of the above-described patent documents and non-patent documents, it is impossible to realize a solid-state magnetic memory capable of random access at room temperature for the reasons already described.

Patent Document 3 discloses an oxide compound having a Y-type ferrite structure. However, Patent Document 3 does not disclose the ferrite contained in the film according to the present embodiment, that is, the ferrite represented by the general formula (Ba₁₋ₓSrₓ)₂Co₂Fe_{12-y-δ}Al_{y}X_{δ}O₂₂.

As described above, the magnetization direction of the film 14 can be controlled by application of a pulsed electric field without using a current magnetic field or spin-transfer torque. Therefore, in the element 1 using the film 14, generation of Joule heat is suppressed, resulting in a reduction in power consumption. In addition, since the magnetization direction of the film 14 can be controlled at room temperature, the element 1 can be operated at room temperature. Therefore, the element 1 has high practicality.

### (Modification)

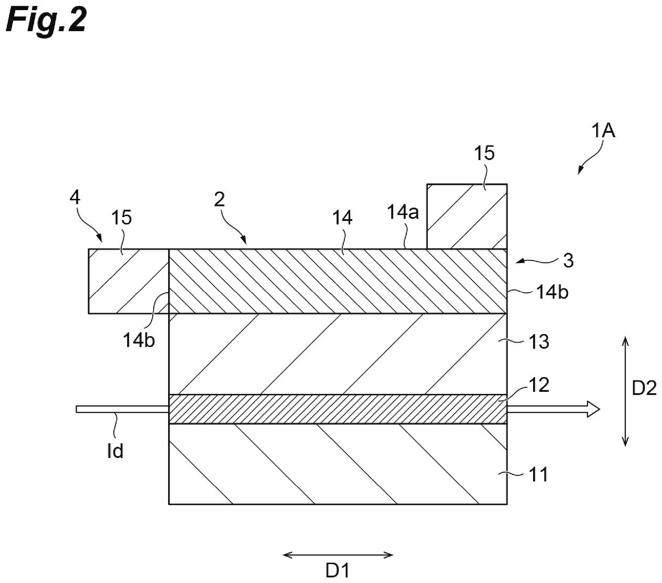

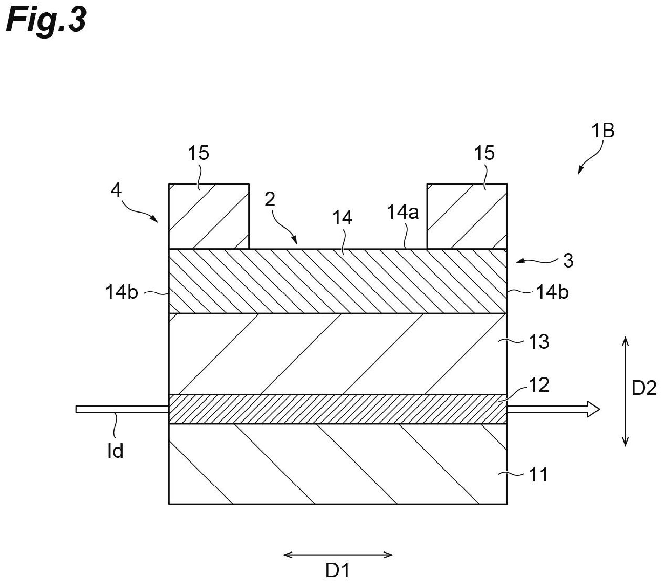

As long as the pair of conductive layers 15 are provided on the film 14 so as to be spaced apart from each other in the first direction D1, they may be provided at locations other than the side surface 14b of the film 14. FIG. 2 is a cross-sectional view showing an element according to a first modification. As shown in FIG. 2, in an element 1A according to the first modification, one of the conductive layers 15 is provided on the side surface 14b of the film 14, and the other conductive layer 15 is provided on the upper surface 14a. FIG. 3 is a cross-sectional view showing an element according to a second modification. As shown in FIG. 3, in an element 1B according to the second modification, both of the pair of conductive layers 15 are provided on the upper surface 14a of the film 14.

In the element 1A and the element 1B as well, similarly to the element 1, by applying a voltage between the pair of conductive layers 15, an electric field in the horizontal direction (first direction D1) can be applied to the film 14. In addition, the pair of conductive layers 15 are provided such that the distance (shortest distance) between the pair of conductive layers 15 in the first direction D1 is 1 nm or more and less than 18 µm.

### (Second Embodiment)

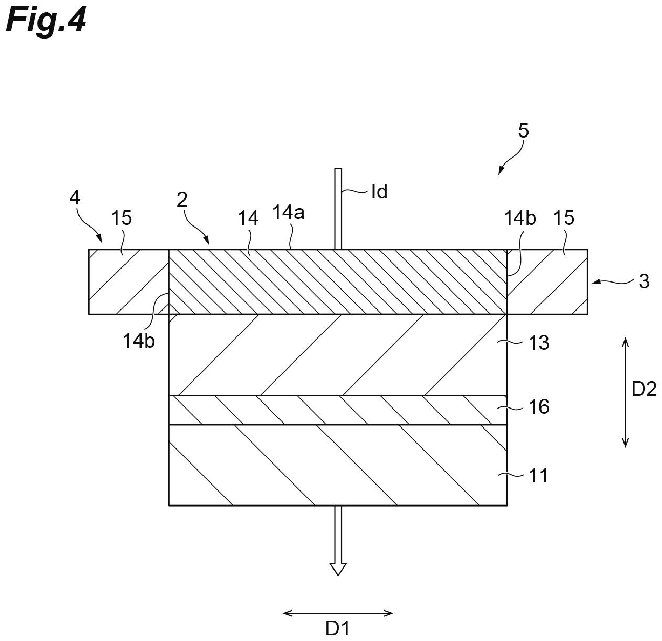

FIG. 4 is a cross-sectional view showing an element according to the second embodiment. In the following, the second embodiment will be described focusing on differences from the first embodiment. An element 5 according to the second embodiment is a TMR (Tunnel Magnetoresistance) type element. Examples of a device according to the second embodiment that includes the element 5 include electronic devices similar to those of the device according to the first embodiment. As shown in FIG. 4, the element 5 differs from the element 1 in that it includes a tunnel insulating layer 16 instead of the non-magnetic metal layer 12 (see FIG. 1).

The tunnel insulating layer 16 is a spacer layer interposed between the ferromagnetic layer 11 and the ferromagnetic layer 13. The tunnel insulating layer 16 electrically and magnetically separates the ferromagnetic layer 11 and the ferromagnetic layer 13 from each other. The tunnel insulating layer 16 contains an insulator. Examples of the insulator include magnesium oxide (MgO), aluminum oxide (Al₂O₃), and a mixed material thereof. The thickness of the tunnel insulating layer 16 is a thickness sufficient for carriers to tunnel in the thickness direction, and is, for example, 1 nm or more and 2 nm or less. The tunnel insulating layer 16 is deposited by, for example, a sputtering method, an atomic layer deposition method, or an ion plating method. A sputtering method is preferably used.

In the element 5, the laminate 2 is formed by laminating the ferromagnetic layer 11, the tunnel insulating layer 16, the ferromagnetic layer 13, and the film 14 in this order. The laminate 4 is formed by laminating the ferromagnetic layer 11, the tunnel insulating layer 16, the ferromagnetic layer 13, and the structure 3 in this order.

The ferromagnetic layer 11, the tunnel insulating layer 16, and the ferromagnetic layer 13 form an MTJ (Magnetic Tunnel Junction). That is, when the magnetization direction of the ferromagnetic layer 13, which is the magnetization free layer, is the same as the magnetization direction of the ferromagnetic layer 11, which is the magnetization pinned layer (parallel state), the electrical resistance of the MTJ decreases, and when it is opposite (antiparallel state), the electrical resistance of the MTJ increases.

In the element 5 as well, by controlling the voltage applied between the pair of conductive layers 15 to reverse the magnetization direction of the film 14, the magnetization direction of the ferromagnetic layer 13 is reversed, resulting in a change in the electrical resistance of the MTJ. The change in the electrical resistance of the MTJ can be detected by measuring a current Id flowing through the element 5 in the vertical direction (second direction D2).

In the element 5 as well, as long as the pair of conductive layers 15 are provided on the film 14 so as to be spaced apart from each other in the first direction D1, they may be provided at locations other than the side surface 14b of the film 14. For example, in the element 5 as well, the pair of conductive layers 15 may be arranged in the same manner as in the element 1A or the element 1B.

The present invention is not necessarily limited to the above-described embodiments and modifications, and various modifications are possible without departing from the spirit thereof. The above-described embodiments and the above-described modifications may be combined as appropriate.

### Examples

Hereinafter, the present invention will be described with reference to examples, but the present invention is not limited to the following examples.

### (Example 1)

### <Preparation of Sample>

As Example 1, a thin film sample of Y-type hexaferrite represented by Ba_{0.8}Sr_{1.2}Co₂Fe_{11.05}Al_{0.9}Cr_{0.05}O₂₂ was prepared. The preparation procedure is described below. First, SrCO₃ (2.2 g), BaCO₃ (3.0 g), Co₃O₄ (2.4 g), Fe₂O₃ (13.4 g), Al₂O₃ (0.7 g), and Cr₂O₃ (0.06 g) were mixed and reacted in air at 1150°C for 24 hours to obtain a precursor. Subsequently, the precursor was heated for 14 hours to obtain a rod.

Subsequently, a single crystal of Y-type hexaferrite was grown from the rod using a laser floating zone method in an oxygen atmosphere at 10 atm. The growth direction of the single crystal was parallel to the a-axis of the crystal. The obtained rod-shaped single crystal ingot of Y-type hexaferrite (7 mm in diameter, 10 cm in length) was cut into a disk shape. Subsequently, after the disk-shaped sample was sealed in a vacuum quartz tube, Ag₂O was introduced into the quartz tube as an oxygen source, and the sample was annealed in an oxygen atmosphere at 10 atm for 100 hours. This yielded a disk of Y-type hexaferrite.

Subsequently, using an FIB apparatus (manufactured by Thermo Fisher Scientific, model number: Helios 5 UX), a beam of ionized gallium (Ga) was irradiated onto the disk of Y-type hexaferrite, and the disk was microfabricated such that the c-axis of the crystal was oriented in-plane and the dimensions were 2 µm in length, 2 µm in width, and 1 µm in thickness, to obtain a thin film sample.

Subsequently, an insulating substrate formed by providing an insulating film (300 nm) on a silicon substrate was prepared. The thin film sample was placed on the prepared insulating substrate, and a pair of conductive layers were deposited on both ends of the thin film sample in the b-axis direction of the crystal. The pair of conductive layers are platinum two-terminal electrodes. The distance between the electrodes was 2 µm. Subsequently, as a treatment to compensate for oxygen vacancies caused by Ga ion irradiation on the surface of the microfabricated sample, annealing was performed at 400°C for 1 hour under a flow of ozone gas excited by ultraviolet light.

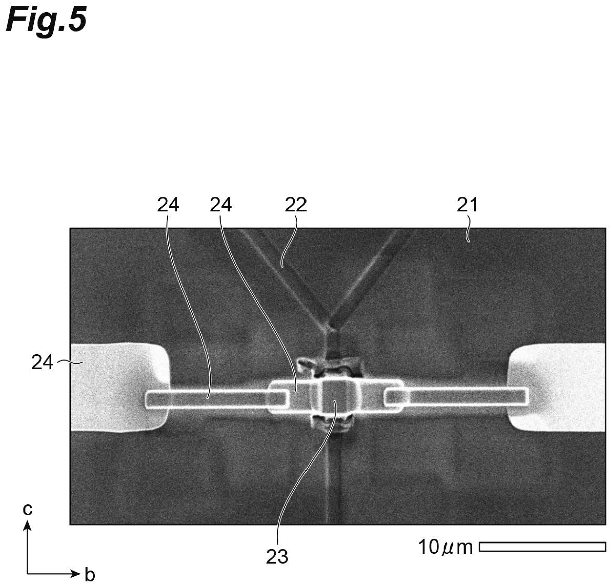

FIG. 5 is an SEM image showing the arrangement of the insulating substrate, the thin film sample, and the pair of conductive layers. As shown in FIG. 5, a groove 22 is provided on the surface of an insulating substrate 21. A thin film sample 23 is placed on the insulating substrate 21 such that the b-axis direction of the crystal is in the horizontal direction of FIG. 5 and the c-axis direction of the crystal is in the vertical direction of FIG. 5. The thin film sample 23 is bridged over the groove 22 extending parallel to the c-axis direction of the crystal. A pair of conductive layers 24 are provided at both ends of the thin film sample 23 in the b-axis direction of the crystal. Since the pair of conductive layers 24 are arranged so as to sandwich the groove 22, the occurrence of short circuits and leakage current is suppressed.

### <Confirmation of Electric-Field-Induced Magnetization Reversal>

Confirmation of electric-field-induced magnetization reversal was performed on the Y-type hexaferrite thin film according to Example 1 using MFM (Magnetic Force Microscopy). In order to perform electric-field-induced magnetization reversal, a spin arrangement is utilized in which a magnetization vector M and a polarization vector P are orthogonal to each other in an ordered phase called the FE3 phase.

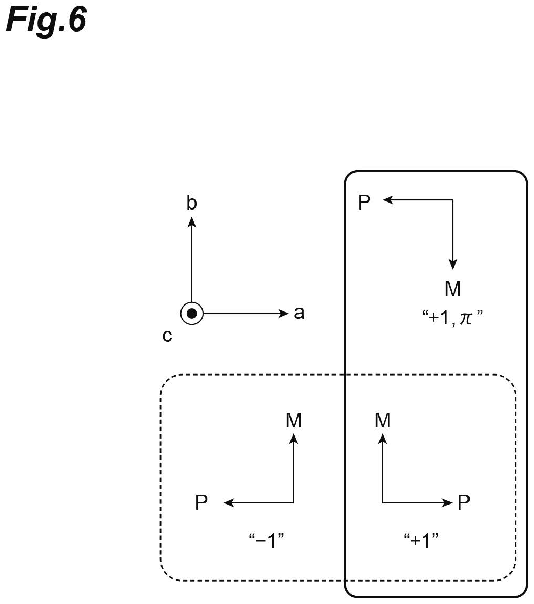

FIG. 6 is a schematic diagram showing the magnetoelectric states of the Y-type hexaferrite thin film. The dashed-line frame in FIG. 6 shows two magnetoelectric states realized under a high magnetic field of 5 T (Tesla) or more. In the forced ferromagnetic state of 5 T or more, the directions of the magnetization vectors M are all aligned in one direction. In contrast, the direction of the polarization vector P is a direction that makes an angle of ±90 degrees with respect to the direction of the magnetization vector M. The magnetoelectric state in the case of +90 degrees is defined as the "+1" state, and the magnetoelectric state in the case of -90 degrees is defined as the "-1" state.

In order to form a single magnetoelectric state, a magnetic field of 5 T was applied in the out-of-plane direction (a-axis direction of the crystal) at 300 K, and a voltage of -10 V (corresponding to an electric field of -5 MV/m) was applied to the voltage terminals (i.e., between the pair of conductive layers) for several seconds. This formed only the "+1" state within the sample (magnetoelectric poling operation). Thereafter, the magnetic field was returned from 5 T to 0 T. At zero magnetic field, the state in which the magnetization vectors are aligned is energetically unstable. For this reason, while the magnetization vector M and the polarization vector P maintain their relative relationship, some of the "+1" states rotate by 180 degrees to become the "+1, π" state. The solid-line frame in FIG. 6 shows the magnetoelectric states realized at zero magnetic field after the magnetoelectric poling operation under a high magnetic field.

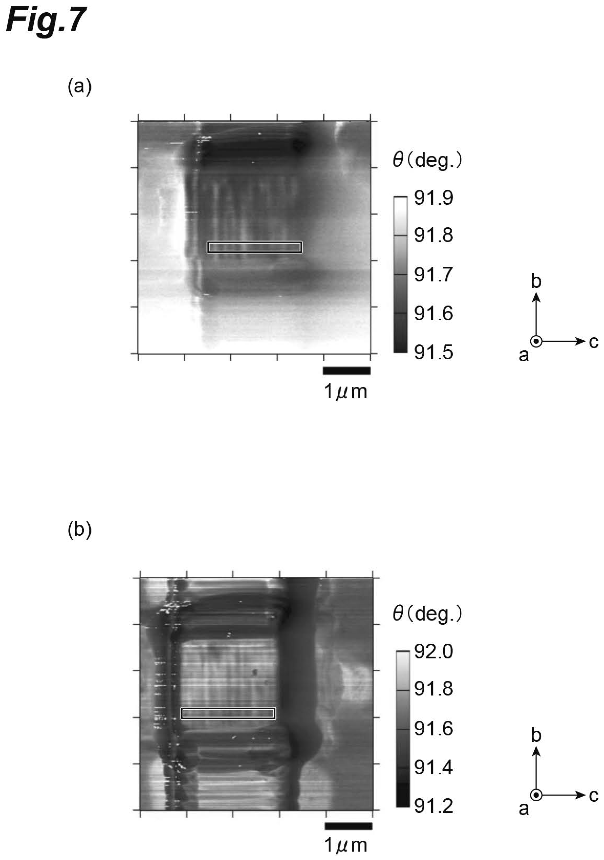

After returning to zero magnetic field as described above, the magnetic texture at room temperature and zero magnetic field was observed using MFM (see FIG. 7(a)). Next, in order to perform magnetization reversal, a rectangular pulse voltage with a time width of 0.1 ms and a voltage of 10 V (corresponding to an electric field of -5 MV/m) was applied five times at room temperature and zero magnetic field. Thereafter, the magnetic texture at room temperature and zero magnetic field was again observed using MFM (see FIG. 7(b)).

FIG. 7(a) is an MFM image showing the magnetic texture of the Y-type hexaferrite thin film according to Example 1 after a poling treatment. The signal intensity of MFM is indicated by the phase angle (deg) of the resonant motion of a cantilever on which a magnetic thin film is deposited. In MFM, since the resonance characteristics of the cantilever change depending on the magnetization state of the sample, the phase angle of the resonant motion of the cantilever reflects the magnetization state of the sample. As shown in FIG. 7(a), after the poling treatment, a stripe-shaped magnetic texture was observed due to the mixture of the "+1" state and the "+1, π" state. In this magnetic texture, a plurality of lines parallel to the b-axis direction are arranged in the c-axis direction of the crystal.

FIG. 7(b) is an MFM image showing the magnetic texture of the Y-type hexaferrite thin film according to Example 1 after application of a pulsed electric field. As shown in FIG. 7(b), a stripe-shaped magnetic texture was again observed after application of the pulse voltage. However, it was found that the position of the magnetic texture differed before and after the application of the pulse voltage. Note that in the magnetic texture of FIG. 7(b), a plurality of lines parallel to the b-axis direction are arranged in the c-axis direction of the crystal, and a plurality of lines parallel to the c-axis direction are arranged in the b-axis direction of the crystal. Therefore, this magnetic texture can also be described as a lattice pattern.

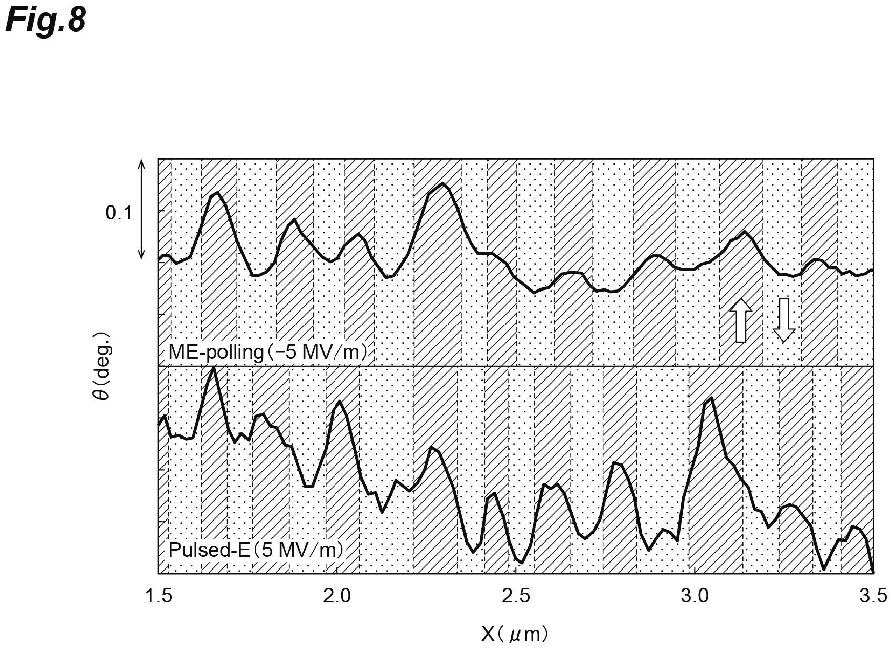

FIG. 8 is a graph comparing changes in signal intensity of the Y-type hexaferrite thin film according to Example 1. A portion of the same location in the magnetic texture images before and after application of the pulse voltage was extracted, and the changes in signal intensity were compared in detail. Here, the changes in signal intensity of the portion indicated by the square frame shown in FIG. 7(a) and FIG. 7(b) were compared. The upper graph in FIG. 8 shows the change in signal intensity before application of the pulse voltage. The lower graph in FIG. 8 shows the change in signal intensity after application of the pulse voltage. The horizontal axis of FIG. 8 indicates the position X (µm) in the c-axis direction within the square frame of FIG. 7(a) and FIG. 7(b). Although the origin of position X is set at a position outside the square frame, the origin of position X can be set at any position. In FIG. 8, the "+1" state is indicated by an upward arrow, and the "+1, π" state is indicated by a downward arrow.

As shown in FIG. 8, the boundary between the "+1" state and the "+1, π" state changed before and after application of the pulse voltage, and local electric-field-induced magnetization reversal was successfully demonstrated. When a voltage of 10 V was applied, the leakage current flowing through the thin film sample of Y-type hexaferrite was approximately 1 nA. Therefore, the electrical energy required for local magnetization reversal is estimated to be approximately 10 × 10⁻⁹ × 10⁻⁴ × 5 = 5 pJ.

As described above, electric-field-induced magnetization reversal was demonstrated using MFM for the Y-type hexaferrite thin film according to Example 1. Therefore, it was confirmed that the film according to the above-described embodiment can be used adjacent to the magnetization free layer of a voltage-driven information storage element and a magnetic functional element.

### (Comparative Example 1)

### <Preparation of Sample>

As Comparative Example 1, a thin film sample of Y-type hexaferrite represented by Ba_{0.8}Sr_{1.2}Co₂Fe_{11.05}Al_{0.9}Cr_{0.05}O₂₂ was prepared, having dimensions of 18 µm in length, 13 µm in width, and 1 µm in thickness. The preparation procedure for the thin film sample according to Comparative Example 1 was the same as the preparation procedure for the thin film sample according to Example 1, except that the sample was processed to have larger dimensions in the length and width directions. The distance between the electrodes was 18 µm.

### <Confirmation of Electric-Field-Induced Magnetization Reversal>

Confirmation of electric-field-induced magnetization reversal was performed on the thin film sample according to Comparative Example 1 using MFM. As described above, in order to form a single magnetoelectric state, it is necessary to apply a magnetic field of 5 T in the out-of-plane direction (a-axis direction of the crystal) at 300 K and to apply an electric field of -5 MV/m to the voltage terminals (i.e., between the pair of conductive layers). Since the thin film sample according to Comparative Example 1 is larger than the thin film sample according to Example 1, an electric field of -5 MV/m corresponds to a high voltage of 90 V. Therefore, after applying the magnetic field of 5 T, the magnetic field was returned to 0 T without applying the electric field. This zero magnetic field state was used as the initial state for MFM observation.

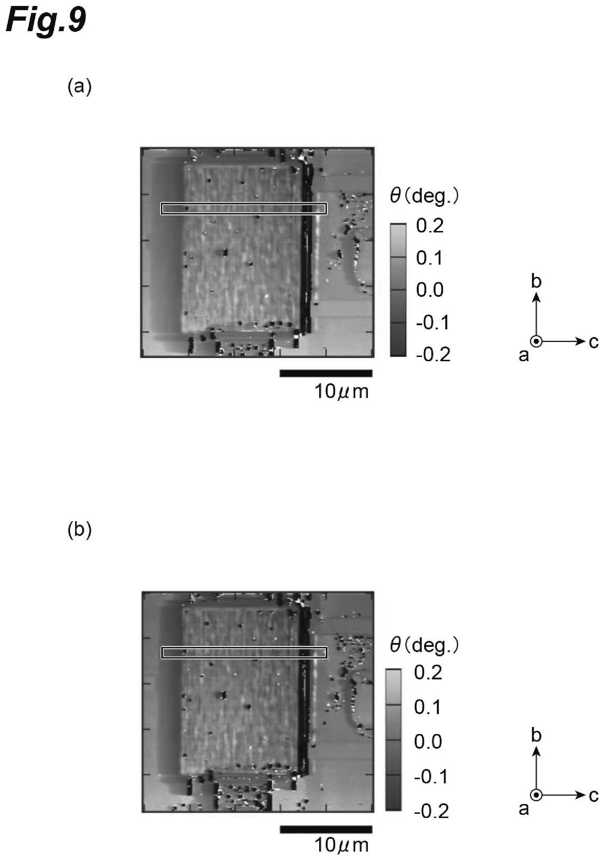

After returning to zero magnetic field as described above, the magnetic texture at room temperature and zero magnetic field was observed using MFM (see FIG. 9(a)). Next, in order to confirm that magnetization reversal does not occur with a pulse voltage of the same magnitude as in Example 1, a rectangular pulse voltage with a time width of 0.1 ms and a voltage of 10 V (corresponding to an electric field of 0.56 MV/m) was applied five times at room temperature and zero magnetic field. Thereafter, the magnetic texture at room temperature and zero magnetic field was again observed using MFM (see FIG. 9(b)).

FIG. 9(a) is an MFM image showing the magnetic texture of the Y-type hexaferrite thin film according to Comparative Example 1 after a poling treatment. As shown in FIG. 9(a), in the initial state, a stripe-shaped magnetic texture was observed due to the mixture of the "+1" state and the "+1, π" state, and the "-1" state and the "-1, π" state. FIG. 9(b) is an MFM image showing the magnetic texture of the Y-type hexaferrite thin film according to Comparative Example 1 after application of a pulsed electric field. As shown in FIG. 9(b), a stripe-shaped magnetic texture was again observed after application of the pulse voltage. It was found that the position of the magnetic texture was substantially the same before and after application of the pulse voltage.

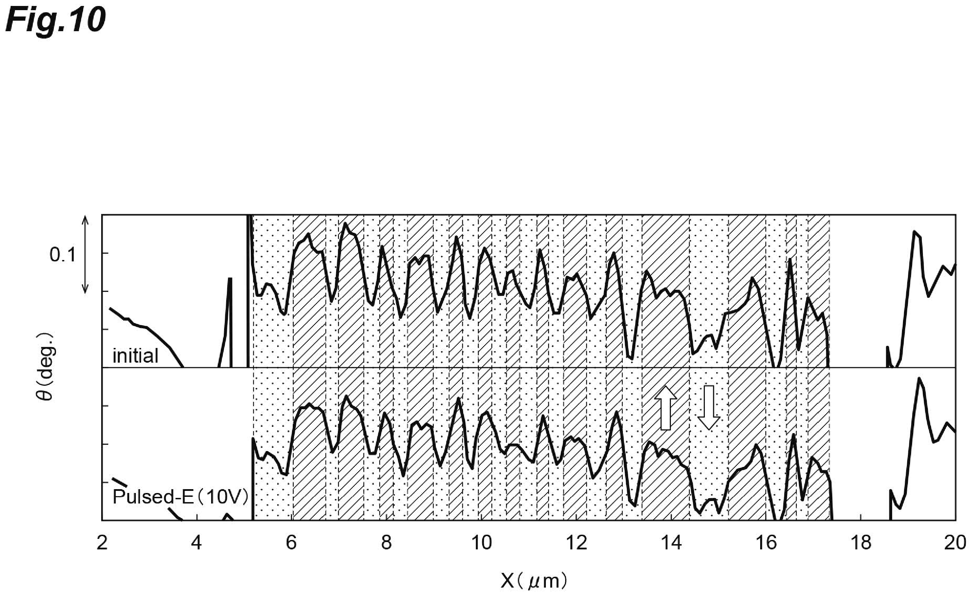

FIG. 10 is a graph comparing changes in signal intensity of the Y-type hexaferrite thin film according to Comparative Example 1. A portion of the same location in the magnetic texture images before and after application of the pulse voltage was extracted, and the changes in signal intensity were compared in detail. Here, the changes in signal intensity of the portion indicated by the square frame shown in FIG. 9(a) and FIG. 9(b) were compared. The upper graph in FIG. 10 shows the change in signal intensity before application of the pulse voltage. The lower graph in FIG. 10 shows the change in signal intensity after application of the pulse voltage. The horizontal axis of FIG. 10 indicates the position X (µm) in the c-axis direction within the square frames of FIG. 9(a) and FIG. 9(b). Although the origin of position X is set at a position outside the square frame, the origin of position X can be set at any position. In FIG. 10, the "+1" state or the "-1" state is indicated by an upward arrow, and the "+1, π" state or the "-1, π" state is indicated by a downward arrow.

From FIG. 10, it was confirmed that the boundary between the "+1" state or the "-1" state and the "+1, π" state or the "-1, π" state hardly changed. This demonstrated that local electric-field-induced magnetization reversal does not occur in Comparative Example 1.

### (Example 2 and Comparative Example 2)

### <Preparation of Sample>

As Example 2 and Comparative Example 2, thin film samples of Y-type hexaferrite having thicknesses of 69 µm and 147 µm, respectively, were prepared. In the same manner as the preparation procedure for the thin film sample according to Example 1, a rod-shaped single crystal ingot of Y-type hexaferrite (7 mm in diameter, 10 cm in length) was formed, after which the rod-shaped single crystal ingot of Y-type hexaferrite was cut into a disk shape and annealed in an oxygen atmosphere. The obtained disk-shaped samples were polished to obtain Y-type hexaferrite thin films having thicknesses of 69 µm and 147 µm such that the c-axis of the crystal was oriented in-plane.

In order to perform electric-field-induced magnetization reversal, a magnetic field of 5 T was applied in the out-of-plane direction (a-axis direction of the crystal) at 240 K, and a voltage of 350 V (corresponding to electric fields of 5 MV/m for the 69 µm-thick thin film and 2.4 MV/m for the 147 µm-thick thin film, respectively) was applied to the voltage terminals (i.e., between the pair of conductive layers) for several seconds (magnetoelectric poling operation). Thereafter, the magnetic field was returned from 5 T to 0 T. Subsequently, the magnetic moment was measured at 240 K using a SQUID while varying the applied voltage.

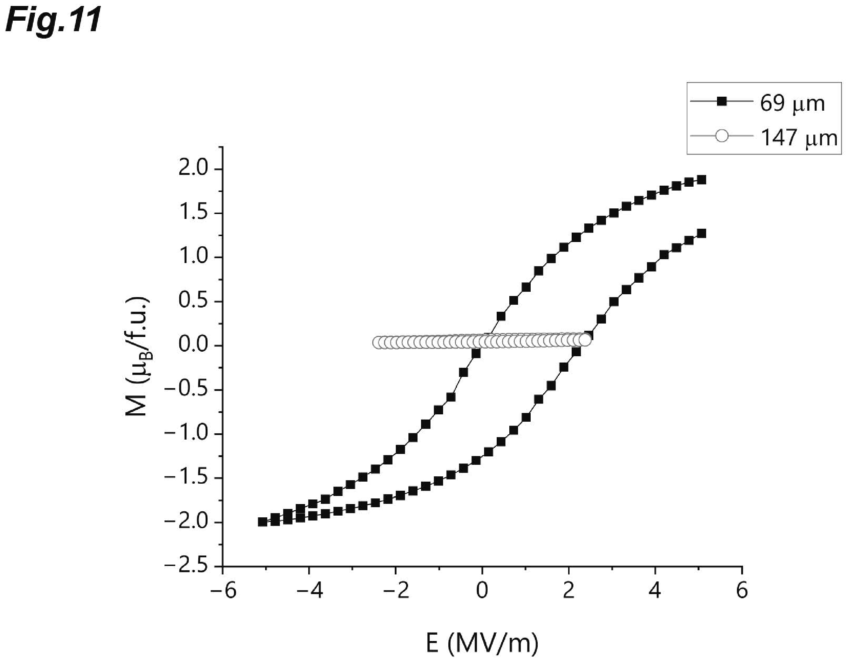

FIG. 11 is a graph showing the electric field dependence of the magnetization of the Y-type hexaferrite thin films according to Example 2 and Comparative Example 2. The vertical axis of FIG. 11 indicates the value of the magnetic moment (µ_{B}/f.u.) obtained by DC magnetization measurement. The horizontal axis of FIG. 11 indicates the value of the applied voltage to the sample during measurement. As shown in FIG. 11, in the 69 µm-thick thin film, the polarity of the magnetic moment is reversed in accordance with the reversal of the polarity of the applied voltage, whereas in the 147 µm-thick thin film, no reversal of the polarity of the magnetic moment is observed. From this, it was confirmed that electric-field-induced magnetization reversal does not occur in the Y-type hexaferrite thin film according to Comparative Example 2 (film thickness: 147 µm) under the same voltage application conditions as those for the Y-type hexaferrite thin film according to Example 2 (film thickness: 69 µm).

### [Supplementary Note]

According to the film, laminate, element, device, and structure of the present disclosure, power consumption can be reduced, and thus it is possible to contribute to Goal 9 of the Sustainable Development Goals (SDGs) led by the United Nations.
- Goal 9: "Build resilient infrastructure, promote inclusive and sustainable industrialization and foster innovation"

### Reference Signs List

1, 1A, 1B: element; 2: laminate; 3: structure; 4: laminate; 5: element; 11: ferromagnetic layer (first ferromagnetic layer); 13: ferromagnetic layer (second ferromagnetic layer); 14: film; 15: conductive layer; D1: first direction; D2: second direction.

## Claims

1. A film containing a ferrite represented by a general formula (Ba₁₋ₓSrₓ)₂Co₂Fe_{12-y-δ}Al_{y}X_{δ}O₂₂,
wherein X is at least one element selected from the group consisting of Cr, Sb, In, and V, $0 \leq x \leq 1 ,$ $0 < y \leq 2 and 0 \leq δ \leq 1 , or 0 \leq y \leq 2 and 0 < δ \leq 1 ,$ and
the film has a thickness of 1.0 nm or more and less than 70 µm.

2. The film according to claim 1, wherein X is Cr.

3. A laminate comprising:
a first ferromagnetic layer that is a magnetization pinned layer;
a second ferromagnetic layer that is a magnetization free layer; and
the film according to claim 1 or 2.

4. An element comprising the laminate according to claim 3.

5. A device comprising the element according to claim 4.

6. A structure comprising:
a film containing a ferrite having a hexagonal crystal structure; and
a pair of conductive layers provided on the film so as to be spaced apart from each other in a first direction parallel to an easy magnetization axis of a crystal of the ferrite,
wherein a distance between the pair of conductive layers in the first direction is 1 nm or more and less than 18 µm.

7. The structure according to claim 6,
wherein the ferrite is represented by a general formula (Ba₁₋ₓSrₓ)₂Co₂Fe_{12-y-δ}Al_{y}X_{δ}O₂₂,
X is at least one element selected from the group consisting of Cr, Sb, In, and V, $0 \leq x \leq 1 ,$ and $0 < y \leq 2 and 0 \leq δ \leq 1 , or 0 \leq y \leq 2 and 0 < δ \leq 1 .$

8. A laminate comprising:
a first ferromagnetic layer that is a magnetization pinned layer;
a second ferromagnetic layer that is a magnetization free layer; and
the structure according to claim 6 or 7,
wherein the structure, the first ferromagnetic layer, and the second ferromagnetic layer are laminated in a second direction orthogonal to the easy magnetization axis.

9. An element comprising the laminate according to claim 8.

10. A device comprising the element according to claim 9.
